# EUROPEAN PATENT SPECIFICATION

(11) **EP 1 079 001 B1**
(45) Date of publication and mention of the grant of the patent: **15.06.2005**
(21) Application number: 00307081.0
(22) Date of filing: 18.08.2000
(51) Int. Cl.: C23C 16/448

(54) **Dual fritted bubbler**
Sprudelvorrichtung mit zwei Fritten
Barbotteur à double fritte

(30) Priority: 27.12.1999 US 472403; 20.08.1999 US 378274
(43) Date of publication of application: 28.02.2001
(73) Proprietor: MORTON INTERNATIONAL, INC., Chicago Illinois 60606-1596 (US)
(72) Inventor: Rangarajan, Sri Prakash, Malden, Massachusetts 02148 (US); O'Grady, John, Beverly, Massachusetts (US)
(74) Representative: Kent, Venetia Katherine

(56) References cited:
- EP-A- 0 714 999
- GB-A- 2 223 509
- US-A- 4 506 815
- US-A- 4 704 988
- US-A- 5 603 169

## Description

### BACKGROUND OF THE INVENTION

### 1. Field of the Invention

The present invention relates to a vapor generator comprising a high-integrity, high-purity dual chambered chemical vapor deposition (CVD) source vessel. The vapor generator is designed for the unique requirements of vapor phase epitaxy and other chemical vapor deposition equipment used in compound semiconductor and thin-film processes. The vapor generator is designed to safely handle and maintain the highest purity of extremely reactive chemicals.

Specifically, the present invention relates to a dual chambered vapor generator vessel and a method for obtaining steady, i.e. uniform, delivery of a solid organometallic source for chemical vapor deposition systems. A non-uniform delivery rate detrimentally affects the composition of the epitaxial layers grown using a MOVPE (Metal-Organic-Vapor-Phase Epitaxy) system. The present invention also is advantageous when used with MOMBE (Metal-Organic Molecular Beam Epitaxy) and CBE (Chemical Beam Epitaxy) vapor deposition systems.

### 2. Description of the Prior Art

Group Ill-V compound semiconductor materials comprising different monocrystalline layers with varying compositions and with thicknesses ranging from fractions of a micron to a few microns are used in the production of many electronic and more particularly optoelectronic devices such as lasers and photodetectors. Chemical vapor deposition methods using organometallic compounds are conventionally employed in the CVD art for the deposition of metal thin-films or semiconductor thin-films of Group III-V compounds. Compounds conventionally used in the semiconductor industry include cyclopentadienyl magnesium (Cp₂Mg), trimethyl aluminum (TMA), trimethyl gallium (TMG), triethyl gallium (TEG), trimethyl antimony (TMSb), dimethyl hydrazine (DMHy), trimethyl indium (TMI), etc. Solid precursors, such as TMI are used in the MOVPE of indium containing semiconductors. The solid TMI is placed in a cylindrical vessel or container commonly referred to as a bubbler and subjected to a constant temperature wherein the solid precursor is vaporized. A carrier gas, e.g. hydrogen, is employed to pick up the precursor vapor and transport it to a deposition system. Most solid precursors exhibit poor and erratic delivery rates when used in a conventional bubbler-type precursor vessel. Conventional bubblers include both bubbler vessels having a dip-tube attached to the inlet exemplified by the disclosure in U.S. Patent 4,506,815 or the gas-feeding device exemplified by the disclosure in U.S. patent 5,755,885 which has a plurality of gas-ejecting holes in the dip-tube to introduce the carrier gas into the container. These conventional bubbler systems can result in a non-stable, non-uniform flow rate of the precursor vapors especially with solid organometallic precursors. Such non-uniform flow rate produces an adverse affect on the compositions of the semiconductor films being grown in MOVPE reactors. Another bubbler system developed by Morton International. Inc. eliminated the use of a dip - tube. While such dip - tubeless bubbler was found to provide a uniform flow rate, it failed to provide a consistently high concentration of precursor material.

The inability to achieve a stable supply of feed vapor from solid precursors at a consistently high concentration is problematic to the users of such equipment, particularly in the manufacture of semiconductor components. The unsteady organometallic flow rate can be due to a variety of factors: such as progressive reduction in the total surface area of the chemical from which evaporation takes place, channeling through the solid precursor where the carrier gas has minimal contact with the precursor and the sublimation of the precursor solid to parts of the bubbler where efficient contact with the carrier gas is impossible.

Various methods have been adopted to overcome the flow problems such as 1) use of reverse flow bubblers, 2) use of dispersion materials in the precursor materials, 3) employing diffuser plates beneath the bed of solids, 4) employing conical cylinder designs and 5) beating on the cylinder to de-agglomerate the solid precursor. U. S. Patent No. 4,704,988 discloses a bubbler design wherein the vessel is separated by a porous partition into first and second compartments. Vaporized reactive material contained in the first compartment diffuses through the partition into the second compartment where it contacts and is entrained in a carrier gas for transport from the vessel into the appropriate deposition chamber.

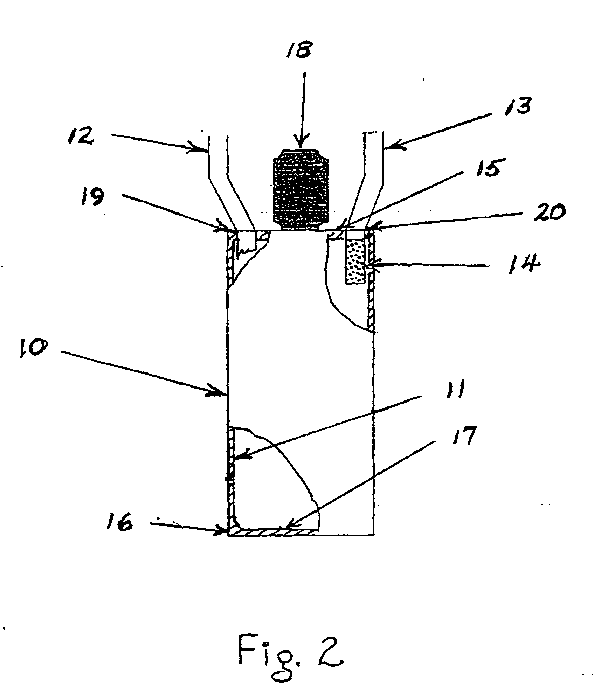

Therefore, as mentioned above the stable flow/pick-up of solid precursor vapor is an ongoing and major drawback associated with prior art bubbler vessels. Present bubbler vessel designs and different delivery configurations fail to provide an uniform flow rate with maximum pick-up of precursor material. Although a single fritted bubbler design as shown in Fig 2 hereof provides better stability and pickup of precursor vapor than prior art bubblers not employing a frit element and are capable of providing improved precursor pickup, there is still a need in the art for bubbler devices that are tailored to provide a uniform and high concentration of the precursor vapors until total depletion of the vapor source. Another bubbler designed to improve precursor pickup is disclosed in U.S. patent 5,603,169 and employs lower and upper porous plates through which the carrier gas passes. The lower porous plate is located above the carrier gas feed inlet and supports the solid precursor load. In operation, carrier gas passes through the lower porous plate before contacting the solid precursor. A compressing plate is located above the lower porous plate for pressing the precursor by its weight. This prior art device comprises a more complex structure than embodied in the simple construction of the present invention.

### SUMMARY OF THE INVENTION

The present invention, in its various aspects, is as set out in the accompanying claims.

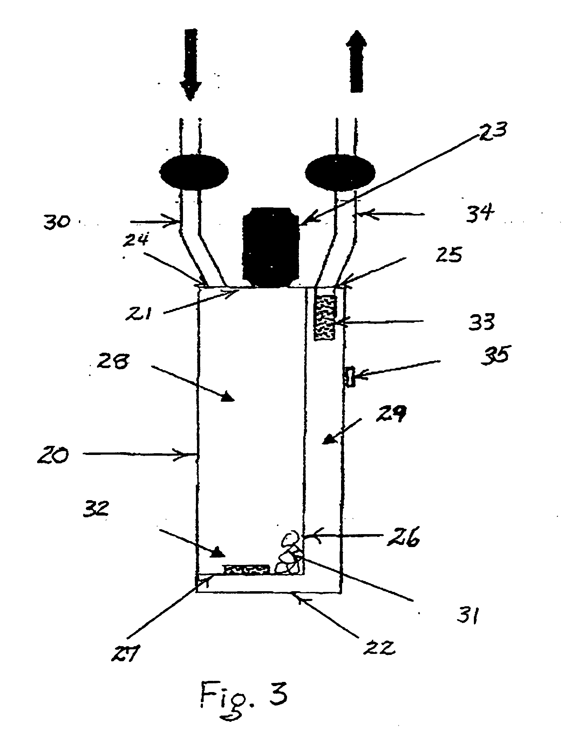

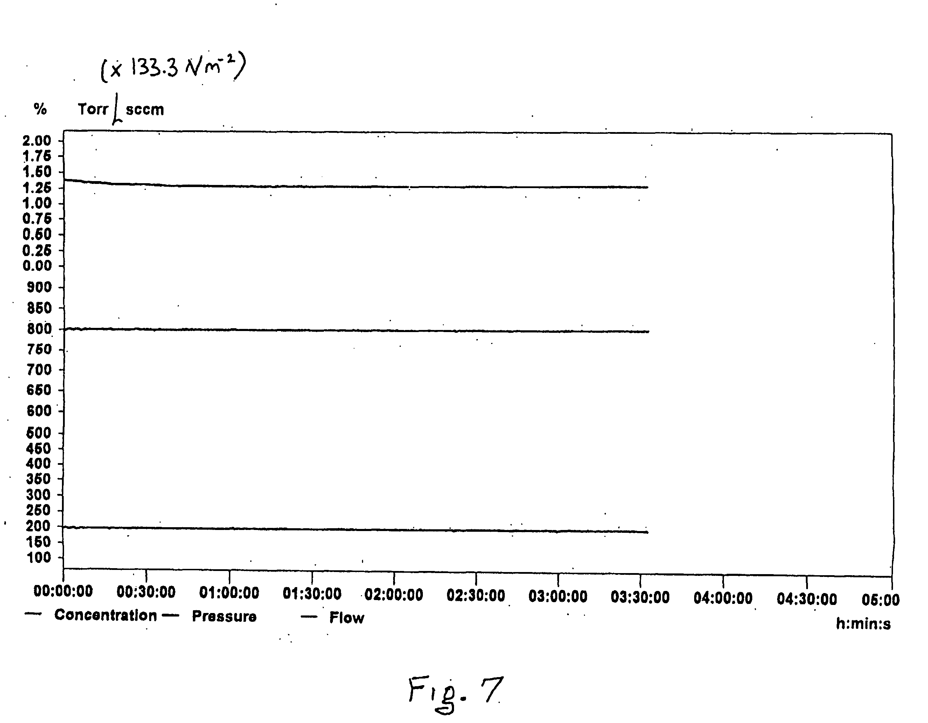

The vapor generator provided by the present invention, is designed to eliminate the poor and erratic delivery rates exhibited by existing prior art designs as well as their inability to provide complete uniform depletion of the precursor material. The novel device of the present invention is designed to operate as a vapor delivery vessel for solid reagent sources. The bubbler device of the present invention by employing dual porous frit elements achieves saturation of the carrier gas with the organometallic vapor without having to bubble the carrier gas through the solid precursor. Avoiding this action prevented the formation of channels in the solid thereby resulting in a uniform delivery of the material until it was depleted as shown in Figure 7. The new dual frit bubbler design of the present invention (Figure 3) overcomes the problems of prior art bubblers not employing porous frit elements by avoiding having to bubble through the solid precursor. The new device design according to the invention can in particular be used in a vapor phase epitaxy system comprising an epitaxy reactor for introducing into the latter at least one of the reagents in the gaseous state, ie. solid organometallic compounds that are used in the semiconductor industry, such as TMI, Cp₂Mg, CBr₄, etc.

An object of the present invention is to provide a vapor delivery device having a simple and economical construction design for delivering a stable/consistent flow at a higher concentration output than possible from existing bubbler designs.

Another object of the present invention is to provide a vapor delivery device design capable of achieving a constant delivery rate until total depletion of the solid organometallic precursor.

According to still another object of the present invention, there is provided a vapor generator design which is capable of achieving rapid responses to changes in temperature and carrier gas flow parameters.

According to a further object of the present invention, there is provided a vapor delivery design capable of achieving a constant flow rate / concentration delivery over a range of concentrations depending upon the operating parameters such as temperature, pressure, nature of the carrier gas and its flow rate.

### BRIEF DESCRIPTION OF THE DRAWINGS

Fig. 1 is a cross sectional view illustrative of a conventional prior art dip tube bubbler.
Fig. 2 is a cross sectional view illustrative of a comparative fritted bubbler.
Fig. 3 is a cross sectional view illustrative of the dual fritted bubbler of the present invention.

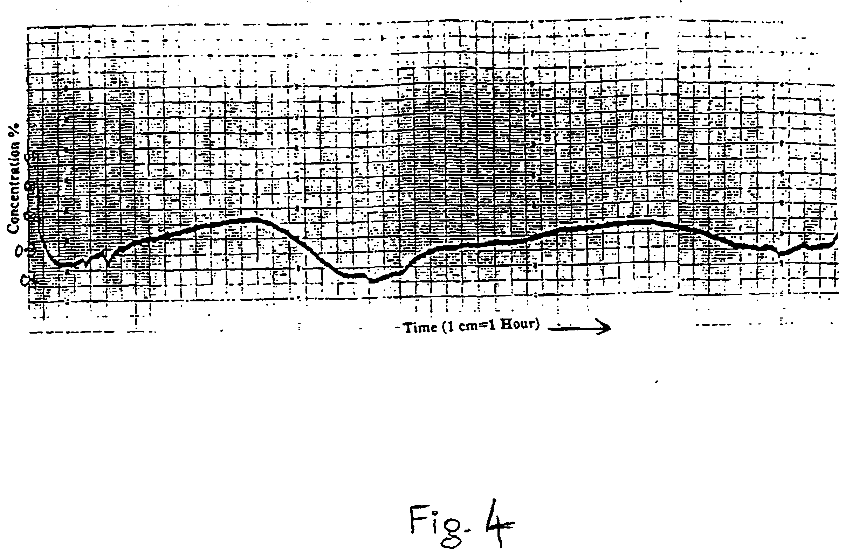

Fig. 4 is an Epison plot showing the % concentration delivery profile of TMI for the Fig. 1 prior art device.
Fig. 5 is an Epison plot showing the % concentration delivery profile of TMI for the Fig. 2 device.
Fig. 6 is an Epison plot showing the % concentration delivery profile of TMI as a function of temperature and flow rates for the Fig. 2 device.
Fig. 7 is an Epison plot showing the % concentration delivery profile of TMI for the Fig. 3 device of the present invention.
Fig. 8 is an Epison plot showing the % concentration delivery profile as a function of hydrogen flow rate of TMI for the Fig. 3 device of the present invention.

### DETAILED DESCRIPTION OF THE PREFERRED EMBODIMENTS

The gas-feeding device of the present invention comprises a dual chambered cylindrically shaped vessel for producing saturated vapors of solid organometallic precursor using a carrier gas. The material used for constructing the vessel is not limited and may be either glass, teflon or metal provided that it is inert to the organometallic compound being processed therein. Usually, metals are employed for safety reasons. Stainless steels are particularly preferred. For example, the entire assembly can be made from 316 L stainless steel. The carrier gas may comprise any inert gas which does not react with the organometallic compound. Examples of carrier gases which may be used in carrying out the invention include hydrogen, nitrogen, argon, and helium. The vessel is filled with the solid precursor organometallic compound through an appropriate fill port on the top of the vessel.

The vessel containing the solid precursor source may be placed in a thermostatic bath and maintained at a suitable temperature. The temperature range to which the vessel is heated will depend on the vaporization temperature of the particular precursor organometallic compound. Any system of heating the vessel to the appropriate temperature will suffice as long as it provides the heat required to vaporize the solid precursor material. For example, the vessel can be heated either by the use of a halocarbon oil flowing through a copper tube surrounding the bubbler or by direct immersion into a heated oil bath. The carrier gas enters the input chamber of the device through an inlet at the top of the vessel and after it has been saturated with the vapors of the organometallic compound the carrier gas stream exits the input chamber of the device through a first porous frit element located in the floor of the inlet chamber into an outlet chamber which is in fluid contact with the inlet chamber and then exits the vessel through a second porous frit element located at the outlet of the vessel. Preferably, the second porous frit element is attached to the inside surface of that portion of the outlet tube located inside the bubbler. A standard mass flow controller (not shown) controls the flow rate of the carrier gas. After exiting from the outlet, the carrier gas saturated with organometallic vapor is fed into the appropriate deposition chamber.

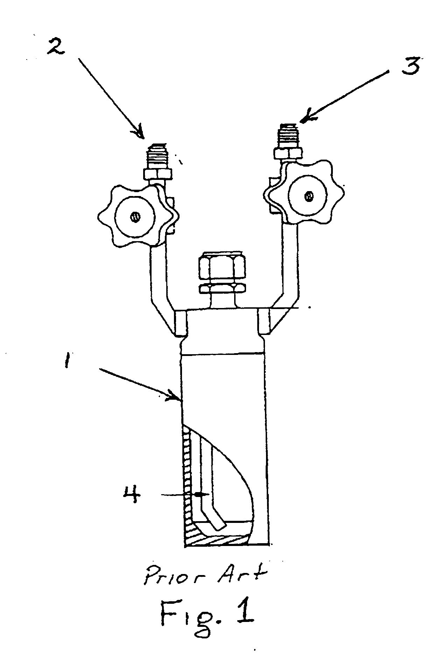

Fig. 1 illustrates a prior art dip-tube bubbler design of the type disclosed in U.S. Patent No. 4,506,815 comprising an elongated cylindrical container **1**, an inlet tube **2** for delivering carrier gas, and an outlet tube **3** for exhausting the precursor vapor which terminates in a dip-tube **4** which extends into the precursor material contained in container **1**.

Fig. 2 shows a comparative apparatus an elongated cylindrical container **10** having an inner surface **11** defining a substantially constant cross section throughout the length of cylinder **10**, a top dosure portion **15** and a bottom metallic closure portion **16** having a flat bottom portion **17**. Top closure portion **15** has fill port **18,** inlet **19** and outlet **20** openings. Inlet tube **12** and outlet tube **13** communicate with inlet opening **19** and outlet opening **20** in closure portion **15** of the container. The lower end of tube **13** terminates at a location above the level of the precursor load which is added through port **18** in container **10**, i.e. it does not dip into the organometallic contents. Outlet tube **13** has porous cylindrically shaped element **14** positioned on its inside surface. The entire assembly is made from stainless steel such as, 316L stainless steel. By way of example, porous element **14** is about 1 in. long with a 1/4 in. outside diameter. The outside diameter of porous frit element **14** is dimensioned to provide a tight fit with the inside diameter of outlet tube **13**. The pore size of element **14** may vary from 1-10 microns.

Fig. 3 illustrates the dual frit bubbler design of the present invention. A cylindrically shaped vessel **20** having a top closure portion **21** and a bottom closure portion **22** is used for producing saturated vapors of the solid precursor organometallic compound using a carrier gas. Top closure portion **21** has fill port **23**, inlet **24** and outlet **25** openings. Vessel **20** is partitioned by wall **26** and floor **27** into inlet **28** and outlet **29** chambers. Examples of the carrier gases include nitrogen, argon and helium. The carrier gas enters through inlet tube **30** at the top of vessel **20** and is passed through the organometallic solid **31** contained in inlet chamber **28**. The carrier gas becomes saturated with the organometallic compound and exits through porous frit disc **32** in floor **27** into outlet chamber **29**. The saturated carrier gas exits vessel **20** by way of outlet tube **34** after passing through porous frit **33** located at the outlet **25** of vessel **20**. By way of example, porous frit element **32** is disc shaped having a diameter of 1 in. (25 mm) and a thickness of 0.125 in. (3 mm) and frit element **33** is cylindrically shaped having a length of 1 in. (25 mm) and a diameter of 0.25 in. (6 mm). The organometallic precursor exiting vessel **20** is delivered to a conventional deposition chamber, not shown. Vessel **20** is filled with the precursor metalorganic compound through fill port **23**. A port **35** can be provided in the wall of vessel **20** to facilitate cleaning. The port can be opened for washing and closed while filling with organometallic. A conventional mechanism (not shown) can be employed to facilitate the opening and dosing of port **35**. Vessel **20** may be placed in a thermostatic bath (not shown) and maintained at a suitable temperature for vaporizing the solid organometallic precursor.

The following examples are given in a non limiting manner for illustrating the invention.

In these examples use is made of a porous frit element constituted by a cylinder of about 1 in. (25 mm) length with a 1/4 in. (6 mm) outside diameter and a disc having a diameter of 1 in. (25 mm) and a thickness of 0.125 in. (3 mm) made from a sintered 316 L stainless steel having a porosity of 10 µm obtained from Mott Metallurgical Corporation. The porous frit elements can also be made from any compatible metallic or non-metallic material having a pore size varying from about 1 to about 10 µm. Other suitable metals suitable for the porous element include 304 L SS, 321 SS, 347 SS, 430 SS, MONEL, INCONEL, HASTELLOY, and Alloy 20. Non-metals such as glass and teflon can be used for the porous frit so long as they exhibit the required controlled porosity. While particularly shaped porous elements have been specifically described, the specific geometric shapes of the porous frit element are not critical as long as the controlled porosity required for achieving the desired stable flow characteristics is maintained.

### Example 1

40 gms. semiconductor grade trimethg-indium charge was placed in the dual fritted bubbler of Fig. 3 and a trimethyhindium charged hydrogen stream was obtained by using a hydrogen carrier. The system pressure was maintained at 800 torr (106 kN m⁻²) with a 200 sccm hydrogen flow rate. The bubbler maintained a uniform concentration of about 1.3%. The experiment was carried out at 50° C for about 3.5 hours. The Epison plot for the delivery profile is shown in Fig. 7.

### Example 2

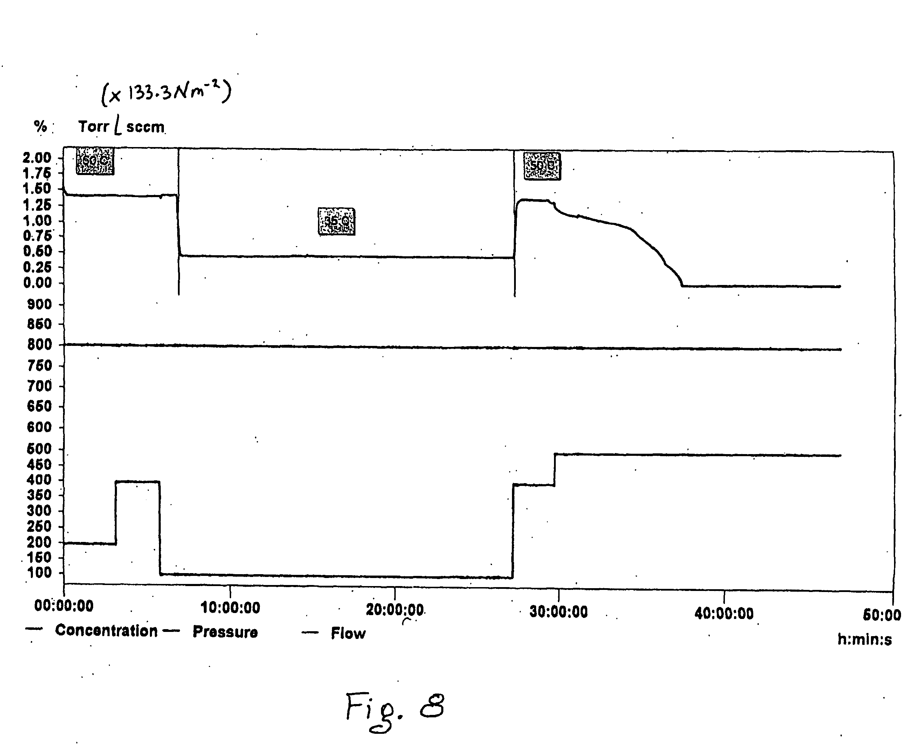

35 gms. charge of semiconductor grade trimethyl-indium was placed in the dual fritted bubbler of Fig. 3 and hydrogen was used as the carrier gas. The Epsilon plot for the delivery profile of TMI is shown in Fig. 8 and was obtained using varying hydrogen gas flow rates between 100 sccm and 500 sccm, a system pressure of 800 torr (106 kN m⁻²) and a temperature varied between 35° C and 50° C. The TMI flow was constant at all operating conditions except when the TMI was depleted.

### Comparative Example 1

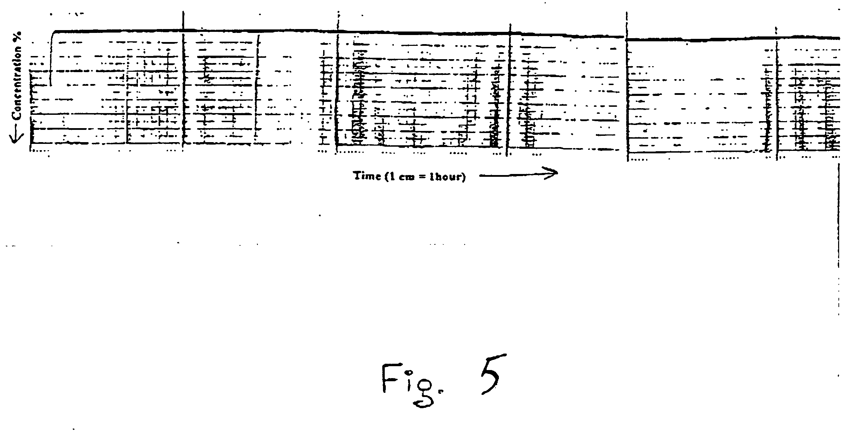

An experiment was run using the bubbler described with reference to Fig. 2, using a 10 g solid semiconductor grade trimethylindium charge was placed in the source bubbler (Fig. 2) and a trimethyl-indium-charged nitrogen stream was obtained by issuing a carrier gas N₂ flowed at a rate of 80 sccm and maintaining a temperature of 40 °C. Over a 100 hour period the concentration of the TMI flow was observed to be delivered at a steady flow rate with an average concentration of about 0.12%. 5 g of TMI was left in the bubbler. An Epison device is used to plot the delivery profile of TMI as shown in Fig. 5. An Epison device measures the concentration of a chemical vapor in another inert gas, usually H₂, N₂ or argon.

### Comparative Example 2

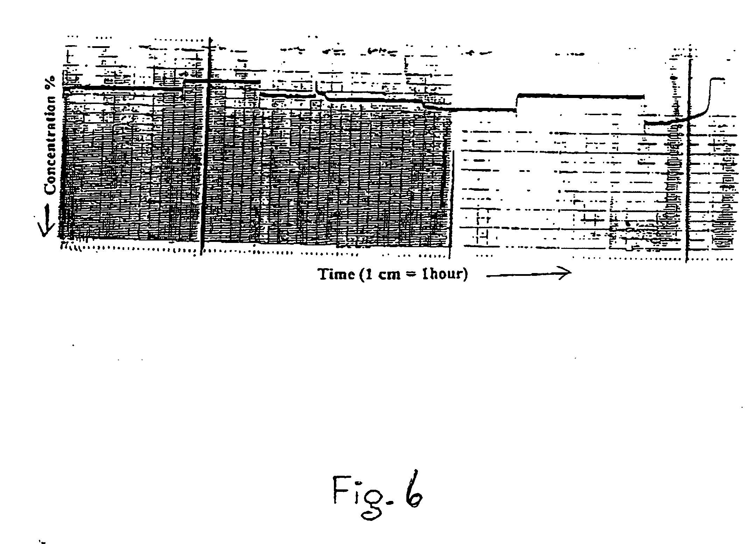

A second experiment was run with the bubbler shown in Fig 2 using a 5 g semiconductor grade trimethyl-indium charge was placed in a source bubbler (Fig. 2) and a trimethyl-indium charged nitrogen stream was obtained by using varying nitrogen gas flow rates between 80 and 400 sccm and temperatures between 40 and 55° C, according to the following sequence: 80 sccm at 40° C, 200 sccm at 40° C, 400 sccm at 40° C, 80 sccm at 40° C, 80 sccm at 50° C, 80 sccm at 55° C, 200 sccm at 55° C and 400 sccm at 55° C. Over a 72 hour period the concentration of the TMI was steady at each set of operating parameters. The TMI was completely depleted from the bubbler at the end of the experiment. The Epison plot for the delivery profile of TMI at the different set of conditions is shown in Fig. 6.

The above Examples demonstrate that the dual fritted bubbler design of the invention provides significant advantages over the prior art delivery systems of the comparative Examples in that the inventive dual fritted bubbler supplies the reagent at a uniform flow rate whereas the device in the comparative examples provides erratic delivery. The advantage of the dual fritted bubbler over the fritted bubbler shown in Fig 2 is that under similar operating conditions the dual fritted bubbler of the present invention delivers a much higher concentration of the solid precursor vapors. This is important in the operation of MOVPE devices when high growth rates or deposition over large areas is desired. In the dual fritted bubbler, the the carrier gas passes through the bed of solid organometallic precursors and becomes saturated before exiting through the porous frit located in the floor of the inlet chamber. This results in a level of saturation that cannot be acheived by simply passing the carrier gas over the solid precursor. This specific feature of the dual fritted bubbler results in a higher concentration output than is possible with prior bubbler designs and the the single fritted bubbler shown in Fig 2.

It is dear that what has been described earlier has been given solely by way of non-limiting example. Variations and modifications are possible without exceeding the scope of the claims. For example, the vapor generator may have a geometric shape other than cylindrical.

## Claims

1. A device for feeding a fluid stream saturated with organometallic compound material to a chemical vapor deposition system comprising,
a vessel including an elongated cylindrical shaped portion having an inner surface defining a substantially constant cross section throughout the length of said cylindrical portion, a top closure portion and a bottom closure portion, said top closure portion having an inlet opening for the introduction of carrier gas and an outlet opening, said elongated cylindrical shaped portion having inlet and outlet chambers in fluid communication wherein the floor of said inlet chamber is spaced from said bottom closure portion and includes a first porous frit which allows vapors generated in said inlet chamber to pass into said outlet chamber.
a source of solid organometallic precursor compound contained within said inlet chamber of said vessel,
said device further comprising a second porous frit located at said outlet opening, whereby said fluid stream exits said vessel by passing through said porous element.

2. A device as specified in claim 1 wherein said outlet comprises a tube which extends from one end within said vessel.

3. A device as specified in claim 2 wherein said second porous frit is attached inside the outlet tube.

4. A device as specified in claim 1 wherein said top closure portion further includes a fill port for loading reactive material into said inlet chamber.

5. A device of claim 1 wherein the porous frit material is comprised of sintered metal.

6. A device of claim 5 wherein the sintered metal comprises stainless steel.

7. A device according to claim 1 wherein the porous frit material comprises glass or teflon.

8. A method for delivering a uniform supply of feed gas substantially saturated with a consistently high concentration of organometallic compound as a function of time which comprises:
loading solid organometallic compound material into the inlet chamber and supplying heat to the vessel of claim 1,
introducing a carrier gas into said inlet chamber of said vessel through a carrier gas inlet tube, said vessel being maintained at a constant temperature sufficient to vaporize said organometallic compound, and
flowing said carrier gas at a sufficient flow rate in contact with said organometallic compound to substantially saturate said carrier gas with said compound,
said compound saturated carrier gas exiting from said inlet chamber through a first porous frit in the floor of the inlet chamber into the outlet chamber of said vessel, where said compound saturated carrier gas flows from said outlet chamber through a second porous frit at the outlet of said vessel,
thereby producing a substantially uniform flow rate of said organometallic compound saturated carrier gas with a substantially consistently high concentration of organometallic compound.

9. A method according to claim 8 wherein the gas substantially saturated with the organometallic compound flowing from said vessel is suitable for use as a feed gas for film formation.

## Patentansprüche

1. Vorrichtung zum Zuführen eines Fluidstroms gesättigt mit metallorganischem Material zu einem chemischen Dampfabscheidungssystem umfassend:
ein Gefäß umfassend einen länglichen, zylindrisch geformten Teil mit einer inneren Oberfläche welche einen im Wesentlichen konstanten Querschnitt über die Länge des zylindrischen Teils definiert, einen oberen Verschlussteil und einen unteren Verschlussteil, wobei der obere Verschlussteil eine Einlassöffnung für die Einführung von Trägergas sowie eine Auslassöffnung aufweist, der längliche, zylindrisch geformte Teil Einlass- und Auslasskammern in Fluidkommunikation aufweist, wobei der Boden der Einlasskammer von dem unteren Verschlussteil beabstandet ist und eine erste poröse Fritte umfasst, die es in der Einlasskammer erzeugten Dämpfen ermöglicht in die Auslasskammer einzutreten,
eine Quelle von fester metallorganischer Vorstufenverbindung enthalten in der Einlasskammer des Gefäßes;
wobei die Vorrichtung ferner eine zweite poröse Fritte umfasst, angeordnet an der Auslassöffnung, wobei der Fluidstrom das Gefäß durch Passieren des porösen Elements verlässt.

2. Vorrichtung nach Anspruch 1, wobei der Auslass ein Rohr umfasst das sich von einem Ende innerhalb des Gefäßes erstreckt.

3. Vorrichtung nach Anspruch 2, wobei die zweite poröse Fritte innerhalb des Auslassrohrs befestigt ist.

4. Vorrichtung nach Anspruch 1, wobei der obere Verschlussteil ferner eine Einfüllöffnung zum Einbringen reaktiven Materials in die Einlasskammer umfasst.

5. Vorrichtung nach Anspruch 1, wobei das poröse Frittenmaterial aus gesintertem Metall besteht.

6. Vorrichtung nach Anspruch 5, wobei das gesinterte Material rostfreien Stahl umfasst.

7. Vorrichtung nach Anspruch 1, wobei das poröse Frittenmaterial Glas oder Teflon umfasst.

8. Verfahren zum Abgeben einer gleichförmigen Einspeisung von Zufuhrgas im Wesentlichen gesättigt mit einer beständig hohen Konzentration von metallorganischer Verbindung als Funktion der Zeit, umfassend:
Einfüllen festen metallorganischen Materials in die Einlasskammer und Zuführen von Wärme zu dem Gefäß des Anspruchs 1,
einführen eines Trägergases in die Einlasskammer des Gefäßes durch ein Trägergaseinlassrohr, wobei das Gefäß bei einer konstanten Temperatur gehalten wird die ausreicht um die metallorganische Verbindung zu verdampfen, und
strömen lassen des Trägergases bei einer ausreichenden Fließgeschwindigkeit in Kontakt mit der metallorganischen Verbindung um das Trägergas mit der Verbindung im Wesentlichen zu sättigen,
wobei das mit der Verbindung gesättigte Trägergas aus der Einlasskammer durch eine erste poröse Fritte im Boden der Einlasskammer austritt und in die Auslasskammer des Gefäßes eintritt, wo das mit der Verbindung gesättigte Trägergas aus der Auslasskammer durch eine zweite poröse Fritte am Auslass des Gefäßes herausfließt,
wobei **dadurch** eine im Wesentlichen gleichförmige Fließgeschwindigkeit des mit der metallorganischen Verbindung gesättigten Trägergases mit einer im Wesentlichen beständig hohen Konzentration an metallorganischer Verbindung erzeugt wird.

9. Verfahren nach Anspruch 8, wobei das aus dem Gefäß herausfließende, im Wesentlichen mit der metallorganischen Verbindung gesättigte, Gas als Zufuhrgas für die Filmbildung geeignet ist.

## Revendications

1. Dispositif pour amener un courant de fluide saturé en un composé organométallique jusqu'à un système de dépôt chimique en phase vapeur, comprenant :
une cuve comportant une partie de forme cylindrique allongée ayant une surface intérieure qui définit une section transversale essentiellement constante sur toute la longueur de ladite partie cylindrique, une partie de fermeture supérieure et une partie de fermeture inférieure, ladite partie de fermeture supérieure ayant un orifice d'entrée pour l'introduction d'un gaz porteur et un orifice de sortie, ladite partie de forme cylindrique allongée ayant des chambre d'entrée et de sortie en communication du point de vue des fluides, où le plancher de ladite chambre d'entrée est espacé de ladite partie de fermeture inférieure et comprend une première fritte poreuse qui permet aux vapeurs générées dans ladite chambre d'entrée de passer dans ladite chambre de sortie,
une source d'un précurseur composé organométallique solide, contenue dans ladite chambre d'entrée de ladite cuve,
ledit dispositif comprenant, en outre, une deuxième fritte poreuse située au niveau dudit orifice de sortie, de façon que ledit courant de fluide sorte de ladite cuve en passant par ladite fritte poreuse.

2. Dispositif selon la revendication 1, dans lequel ledit orifice de sortie comprend un tube qui s'étend depuis une extrémité à l'intérieur de ladite cuve.

3. Dispositif selon la revendication 2, dans lequel ladite deuxième fritte poreuse est attachée à l'intérieur du tube de sortie.

4. Dispositif selon la revendication 1, dans lequel ladite partie de fermeture supérieure comprend, en outre, un orifice de remplissage pour le chargement d'un matériau réactif dans ladite chambre d'entrée.

5. Dispositif selon la revendication 1, dans lequel le matériau de la fritte poreuse comprend un métal fritté.

6. Dispositif selon la revendication 5, dans lequel le métal fritté comprend un acier inoxydable.

7. Dispositif selon la revendication 1, dans lequel le matériau de la fritte poreuse comprend du verre ou du téflon.

8. Procédé de délivrance uniforme d'un gaz d'alimentation largement saturé en une concentration constamment élevée en fonction du temps d'un composé organométallique, qui comprend les étapes consistant à:
charger un composé organométallique solide dans la chambre d'entrée et fournir de la chaleur dans la cuve telle que définie dans la revendication 1,
introduire un gaz porteur dans ladite chambre d'entrée de ladite cuve, par l'intermédiaire d'un tube d'entrée de gaz porteur, ladite cuve étant maintenue à une température constante suffisante pour vaporiser ledit composé organométallique, et
faire s'écouler ledit gaz porteur à un débit suffisant de façon à l'amener en contact avec ledit composé organométallique pour largement saturer ledit gaz porteur en ledit composé,
ledit gaz porteur saturé en composé organométallique sortant de ladite chambre d'entrée à travers une première fritte poreuse aménagée dans le plancher de la chambre d'entrée de façon à entrer dans ladite chambre de sortie de ladite cuve, et ledit gaz porteur saturé en composé organométallique s'écoulant hors de ladite chambre de sortie à travers une deuxième fritte poreuse, disposée au niveau de l'orifice de sortie de ladite cuve,
de façon à produire un débit essentiellement uniforme dudit gaz porteur saturé en composé organométallique, avec une concentration en composé organométallique essentiellement constamment élevée.

9. Procédé selon la revendication 8, dans lequel le gaz largement saturé en composé organométallique, s'écoulant hors de ladite cuve, est approprié pour être utilisé comme gaz d'alimentation pour la formation d'un film.
